# EUROPEAN PATENT APPLICATION

(11) **EP 3 579 281 A1**
(43) Date of publication of application: **11.12.2019**
(21) Application number: 18187642.6
(22) Date of filing: 07.08.2018
(51) Int. Cl.: H01L 31/0203, H01L 31/048

(54) **THIN FILM PACKAGE DEVICE AND SOLAR CELL**

(30) Priority: 08.06.2018 CN 201820895089 U
(71) Applicant: Hanergy New Material Technology Co., Ltd., Yanqi Industrial Development Zone Huairou District Beijing 101407 (CN)
(72) Inventor: Pengju, Zhang, Beijing (CN); Shengchun, Li, Beijing (CN); Xiaotian, Tan, Beijing (CN); Zhijian, Yu, Beijing (CN); Yu, Zhang, Beijing (CN)
(74) Representative: Soria Parra, Manuel

(57) **Abstract**

The present invention relates to a thin film package device and a solar cell. The device is used for thin film package of a device to be packaged, and the device includes: a base substrate disposed on a side of the device to be packaged; and a thin film package layer disposed on the other side of the device to be packaged. The thin film package layer includes an inorganic thin film layer and an organic thin film layer, the organic thin film layer includes a first organic thin film layer closest to the base substrate, and the first organic thin film layer includes a plurality of discontinuous first organic thin film blocks. The technical solution can not only achieve the effect of releasing stress, but also can effectively prevent lateral diffusion of moisture above the device to be packaged, thereby avoiding a wide range of moisture erosion.

## Description

### TECHNICAL FIELD

The present invention relates to the technical field of semiconductor packaging, and in particular, to a thin film package device and a solar cell.

### BACKGROUND

In recent years, the increasingly prominent traditional energy issues have promoted the rapid development of new energy sources. Especially the clean energy represented by solar energy has received high-degree and extensive attention. Since the core material in the solar cell module is very sensitive to moisture, and exposure to the atmosphere tends to cause attenuation of power generation efficiency, an effective packaging structure is important for ensuring the power generation efficiency of the solar cell module.

The current common packaging structure includes an alternate stacked packaging structure of an organic thin film and an inorganic thin film. However, due to the limited water-blocking capacity of organic materials, the waterproof effect is not ideal. Especially when the local area has been seriously eroded by moisture, the current packaging structure cannot prevent the further spread of moisture. Based on this, it is urgent to develop a packaging structure having a good waterproof effect to ensure the performance of the solar cell module.

### SUMMARY

To overcome the problems in the related art, embodiments of the present invention provide a thin film package device and a solar cell. The technical solution is as follows.

According to a first aspect of the embodiments of the present invention, there is provided a thin film package device for thin film package of a device to be packaged, wherein the thin film package device includes:
a base substrate disposed on a side of the device to be packaged; and
a thin film package layer disposed on the other side of the device to be packaged,
wherein the thin film package layer includes an inorganic thin film layer and an organic thin film layer, the organic thin film layer includes a first organic thin film layer closest to the base substrate, and the first organic thin film layer includes a plurality of discontinuous first organic thin film blocks.

In an embodiment, the organic thin film layer further includes a second organic thin film layer on a side of the first organic thin film layer facing away from the base substrate, and the second organic thin film layer includes a plurality of second organic thin film blocks interlaced with the first organic thin film blocks.

In an embodiment, the second organic thin film layer further includes an organic connecting portion between adjacent second organic thin film blocks.

In an embodiment, the first organic thin film blocks are arranged in a first direction and/or a second direction, and the first direction and the second direction are perpendicular to each other.

In an embodiment, the inorganic thin film layer includes an inorganic thin film isolation layer between the first organic thin film layer and the second organic thin film layer.

In an embodiment, the inorganic thin film layer further includes a first inorganic thin film layer in contact with the device to be packaged and a second inorganic thin film layer disposed on the outmost side of the thin film package device.

In an embodiment, the organic thin film layer has a thickness of between 1 and 10 µm.

In an embodiment, the device to be packaged includes a photoelectric functional layer and an electrode layer disposed on a surface of the photoelectric functional layer.

According to a second aspect of the embodiments of the present invention, there is provided a solar cell including the above-described thin film package device and a solar cell module.

The technical solution provided by the embodiments of the present invention may include the following beneficial effects. The technical solution provides a segmented organic thin film layer and at least one inorganic thin film layer in the thin film package layer, so that the first organic thin film layer closest to the base substrate is presented as an arrangement of a plurality of first organic thin film blocks. In this way, not only the defective particles in the process in a local region can be covered by the first organic thin film blocks, thereby achieving the effect of releasing stress, but also the thin film package layer can be divided into regions, thereby effectively preventing the diffusion of moisture above the device to be packaged and avoiding suffering from a wide range of moisture erosion. In particular, the segmented organic thin film layer and multiple inorganic thin film layers provided in the thin film package layer can effectively blocking water vapor, which has a good waterproof effect to ensure the performance of the solar cell module.

It should be understood that both the foregoing general description and the following detailed description are exemplary and explanatory only and are not restrictive of the invention.

### BRIEF DESCRIPTION OF THE DRAWINGS

The accompanying drawings herein, which are incorporated in and constitute a part of this specification, illustrate embodiments consistent with the present invention and, together with the description, serve to explain the principles of the present invention.
Fig. 1 is a schematic diagram of a thin film package device according to an exemplary embodiment;
Fig. 2 is a schematic diagram of a thin film package device according to an exemplary embodiment;
Fig. 3 is a schematic diagram of a thin film package device according to an exemplary embodiment;
Fig. 4 is a plan view of a thin film package device according to an exemplary embodiment;
Fig. 5 is a plan view of a thin film package device according to an exemplary embodiment;
Fig. 6 is a plan view of a thin film package device according to an exemplary embodiment;
Fig. 7 is a schematic diagram of a thin film package device according to an exemplary embodiment; and
Fig. 8 is a schematic diagram of a photovoltaic functional layer in a thin film package device according to an exemplary embodiment.

### DETAILED DESCRIPTION

Reference will now be made in detail to exemplary embodiments, examples of which are illustrated in the accompanying drawings. The following description refers to the accompanying drawings in which the same numbers in different drawings represent the same or similar elements unless otherwise represented. The implementations set forth in the following description of exemplary embodiments do not represent all implementations consistent with the present invention. Instead, they are merely examples of devices and methods consistent with aspects related to the present invention as recited in the appended claims.

In the related art, since the core material of the solar cell module is very sensitive to moisture, it is necessary to adopt a specific packaging structure to prevent intrusion of moisture, thereby ensuring power generation efficiency of the solar cell. At present, the common packaging structure includes an externally adhered packaging structure and an alternately stacked packaging structure of an organic thin film and an inorganic thin film, but the packaging effect is not satisfactory, especially when the local area has been subjected to severe moisture erosion. It is impossible to stop the further spread of moisture with the current packaging structure.

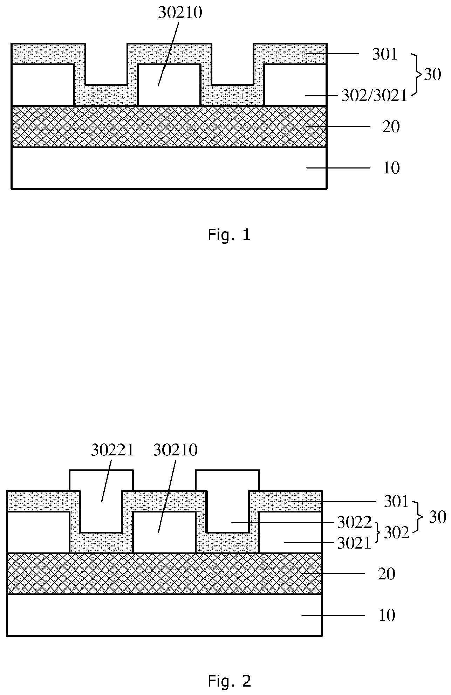

Based on this, the technical solution provided by the embodiments of the present invention relates to a thin film package device, which may be used for thin film package of a device to be packaged such as a solar cell module or other electronic device. As shown in Fig. 1, the thin film package device may include a base substrate 10 and a thin film package layer 30.

The base substrate 10 is disposed on one side of the device 20 to be packaged, for example, under the device 20 to be packaged, and the base substrate 10 may be a flexible substrate or a glass substrate.

The thin film package layer 30 is disposed on the other side of the device 20 to be packaged, for example, above the device 20 to be packaged, and may be used for thin film package of the device 20 to be packaged.

The thin film package layer 30 may include an inorganic thin film layer 301 and an organic thin film layer 302. One of the organic thin film layers 302 which is closest to the base substrate 10 is a first organic thin film layer 3021, and the first organic thin film layer 3021 includes a plurality of discontinuous first organic thin film blocks 30210. That is, the first organic thin film layer 3021 is a segmented organic thin film structure.

According to the technical solution provided by the embodiment of the present invention, the segmented organic thin film layer 302 is disposed in the thin film package layer 30, so that the first organic thin film layer 3021 closest to the base substrate 10 is presented as an arrangement of a plurality of first organic thin film blocks 30210. In this way, not only the defective particles in the process in a local region can be covered by the first organic thin film blocks 30210, thereby achieving the effect of releasing stress, but also the thin film package layer 30 can be divided into regions, thereby effectively preventing the diffusion of moisture above the device 20 to be packaged and avoiding suffering from a wide range of moisture erosion.

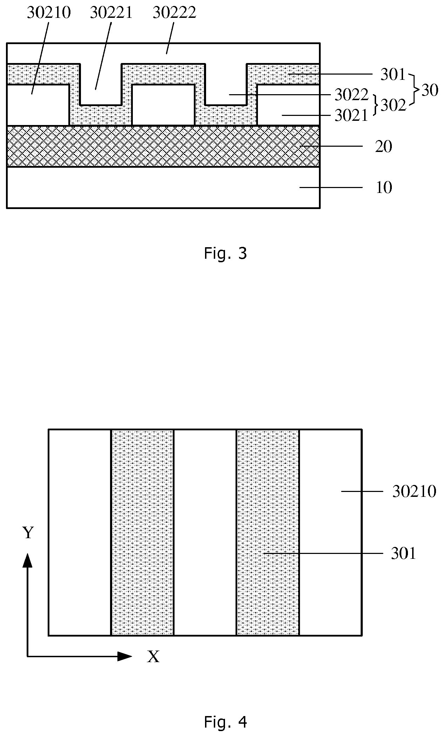

In the exemplary embodiment, as shown in Fig. 2 and Fig. 3, the organic thin film layer 302 may further include a second organic thin film layer 3022 on a side of the first organic thin film layer 3021 facing away from the base substrate 10. The second organic thin film layer 3022 may include a plurality of second organic thin film blocks 30221 interlaced with the first organic thin film blocks 30210. Other film layers may be disposed between the first organic thin film layer 3021 and the second organic thin film layer 3022 in order to separate the two from each other.

In one embodiment, referring to Fig. 2, the second organic thin film layer 3022 may be composed of only a plurality of discontinuous second organic thin film blocks 30221. That is, in the projection of the organic thin film layer 302 on the substrate 10, a plurality of discontinuous regions correspond to the projection of the first organic thin film layer 3021 (i.e., projections of all the first organic thin film blocks 30210), and the remaining plurality of discontinuous regions correspond to the projection of the second organic thin film layer 3022 (i.e., projections of all the second organic thin film blocks 30221), so that the projection of the first organic thin film layer 3021 and the projection of the second organic thin film layer 3022 are interlaced.

In another embodiment, referring to Fig. 3, the second organic thin film layer 3022 may further include an organic connecting portion 30222 between adjacent second organic thin film blocks 30221. That is, the second organic thin film layer 3022 is composed of a plurality of second organic thin film blocks 30221 and organic connecting portions 30222 for connecting adjacent second organic thin film blocks 30221. That is, in the projection of the organic thin film layer 302 on the substrate 10, a plurality of discontinuous regions correspond to projection of the first organic thin film layer 3021 (i.e., projections of all the first organic thin film blocks 30210), the remaining plurality of discontinuous regions and other regions correspond to the projection of the second organic thin film layer 3022 (i.e., projections of all the second organic thin film blocks 30221 and the organic connecting portions 30222 therebetween). In this way, the projection of the second organic thin film layer 3022 may completely cover the projection of the first organic thin film layer 3021 and the surface of the second organic thin film layer 3022 facing away from the first organic thin film layer 3021 may be planarized.

Specifically, the thickness of each layer of the organic thin film layer 302 may be set in the range of 1 to 10 µm, which may be formed by using a material of a photoresist and by wet coating such as coating or immersion. In this way, at least one organic thin film layer 302 exists in any part of the thin film package device. Since the organic thin film layer 302 may form a large thickness, it may cover the defective particles in the process, thereby achieving an effect of planarization and a buffering effect of releasing stress.

Alternatively, as shown in Fig. 4, the first organic thin film blocks 30210 may be arranged in a first direction such as an X direction to form a unidirectional segmented arrangement. That is, the first organic thin film layer 3021 exhibits a segmented structure only in the first direction and a continuous structure in the second direction, for example, the Y direction.

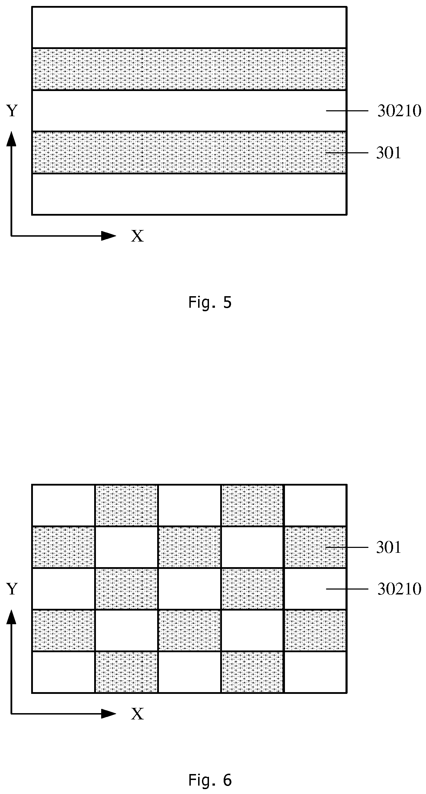

Alternatively, as shown in Fig. 5, the first organic thin film blocks 30210 may also be arranged in a second direction, such as the Y direction, to form a unidirectional segmented arrangement. That is, the first organic thin film layer 3021 exhibits a segmented structure only in the second direction and a continuous structure in the first direction, for example, the X direction.

Alternatively, as shown in Fig. 6, the first organic thin film blocks 30210 may also be arranged in the first direction, for example, the X direction and the second direction, for example, the Y direction, thereby forming a bidirectional segmented arrangement. That is, the first organic thin film layer 3021 is a segmented structure in both the first direction and the second direction.

The first direction and the second direction intersect with each other, and for example, are perpendicular to each other.

Based on the above structure, as shown in Fig. 2 and Fig. 3, an inorganic thin film layer 301 may be disposed between the first organic thin film layer 3021 and the second organic thin film layer 3022 as an inorganic thin film isolation layer 3010 for separating the two from each other. In this way, a barrier wall made of an inorganic thin film material may be formed between the respective first organic thin film blocks 30210 of the first organic thin film layer 3021. Due to the high density and high water-blocking ability of the inorganic thin film material, this arrangement can significantly improve the ability to prevent lateral diffusion of moisture, thereby facilitating the prevention of large-area diffusion of moisture.

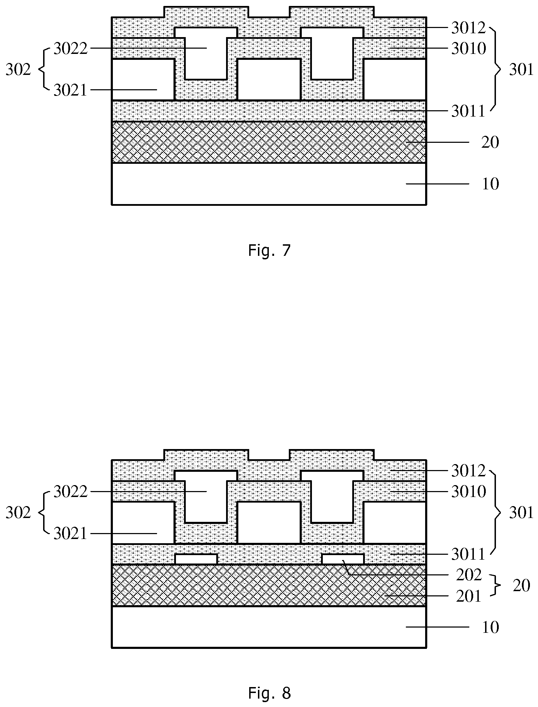

Further, as shown in Fig. 7, the inorganic thin film layer 301 may further include a first inorganic thin film layer 3011 in contact with the device 20 to be packaged and a second inorganic thin film layer 3012 disposed at the outermost side of the thin film package device. On the one hand, considering that the inorganic thin film material has high density and strong water blocking capability, the first inorganic thin film layer 3011 is disposed immediately next to the device 20 to be packaged to provide strong waterproof protection for the device 20 to be packaged. On the other hand, considering that the inorganic thin film material has high surface hardness, strong scratch resistance, and low surface roughness, the second inorganic thin film layer 3012 is disposed at the outmost side of the thin film package device, which can be advantageous for obtaining a better protective effect.

Specifically, referring to Fig. 7, the thin film package device may include a base substrate 10, a device 20 to be packaged above the base substrate 10, and a thin film package layer 30 above the device 20 to be packaged. The thin film package layer 30 may at least include a first inorganic thin film layer 3011 in contact with the device 20 to be packaged, a first organic thin film layer 3021 disposed above the first inorganic thin film layer 3011 and composed of a plurality of discontinuous first organic thin film blocks 30210, an inorganic thin film isolation layer 3010 disposed above the first organic thin film layer 3021, a second organic thin film layer 3022 disposed above the inorganic thin film isolation layer 3010 and having a plurality of second organic thin film blocks 30221, and a second inorganic thin film layer 3012 disposed above the second organic thin film layer 3022. The projections of the first organic thin film blocks 30210 and the second organic thin film blocks 30221 on the base substrate 10 are interlaced with each other. The first organic thin film layer 3021 and the second organic thin film layer 3022 may be made of an organic material such as a photoresist, which may be formed, for example, by wet coating such as coating or immersion. The first inorganic thin film layer 3011, the inorganic thin film isolation layer 3010, and the second inorganic thin film layer 3012 may be any layer made of an inorganic thin film material, such as a silicon nitride thin film layer, a silicon oxide thin film layer, a silicon oxynitride thin film layer, an aluminum oxide thin film layer, or a diamond-like thin film layer, which may be formed, for example, by PECVD (Plasma Enhanced Chemical Vapor Deposition), PVD (Physical Vapor Deposition), or ALD (Atomic Layer Deposition).

Based on the thin film package device shown in Fig. 7, at least three inorganic thin film layers 301 and at least one organic thin film layer 302 are present at any portion. The inorganic thin film layer 301 can effectively block the intrusion of moisture, and the inorganic thin film isolation layer 3010 is disposed between the first organic thin film blocks 30210 and the second organic thin film blocks 30221, thereby preventing lateral diffusion of moisture and avoiding a large area of moisture erosion. In addition, in this embodiment, the organic thin film layer 302 of the segmented structure is employed, and the organic thin film layer 302 and the inorganic thin film layer 301 are alternately stacked, which can also improve the bending property of the thin film package device, making it less prone to cracks, which may increase the toughness of the product.

In the present exemplary embodiment, as shown in Fig. 8, the device 20 to be packaged may include a photoelectric functional layer 201 and an electrode layer 202 disposed above the photoelectric functional layer 201. For example, when the thin film package device is applied to a thin film package of a solar cell module, the photoelectric functional layer 201 may be a core layer of the solar cell module, such as a semiconductor functional layer for realizing photoelectric conversion. However, when the thin film package device is applied to other electronic devices than the solar cell module, the photoelectric functional layer 201 may also be a functional layer of other electronic devices, which is not limited in this embodiment.

The technical solution provided by the embodiments of the present invention further relates to a solar cell, including the above-mentioned thin film package device and a solar cell module. Based on this, by using the thin film package device for the thin film package of the solar cell module, it can not only achieve the effect of releasing stress, but also can effectively prevent lateral diffusion of moisture above the device to be packaged, thereby avoiding a wide range of moisture erosion.

Other embodiments of the invention will be apparent to those skilled in the art from consideration of the specification and practice of the invention disclosed here. This application is intended to cover any variations, uses, or adaptations of the invention following the general principles thereof and including such departures from the present invention as come within known or customary practice in the art. It is intended that the specification and examples be considered as exemplary only, with a true scope of the invention being indicated by the following claims.

It will be appreciated that the present invention is not limited to the exact construction that has been described above and illustrated in the accompanying drawings, and that various modifications and changes may be made without departing from the scope thereof. It is intended that the scope of the invention only be limited by the appended claims.

## Claims

1. A thin film package device for thin film package of a device to be packaged, wherein the thin film package device comprises:
a base substrate (10) disposed on a side of the device (20) to be packaged; and
a thin film package layer (30) disposed on the other side of the device (20) to be packaged,
wherein the thin film package layer (30) comprises an inorganic thin film layer (301) and an organic thin film layer (302), the organic thin film layer (302) comprises a first organic thin film layer (3021) closest to the base substrate (10), and the first organic thin film layer (3021) comprises a plurality of discontinuous first organic thin film blocks (30210).

2. The thin film package device according to claim 1, wherein the organic thin film layer (302) further comprises a second organic thin film layer (3022) on a side of the first organic thin film layer (3021) facing away from the base substrate (10), and the second organic thin film layer (3022) comprises a plurality of second organic thin film blocks (30221) interlaced with the first organic thin film blocks (30210).

3. The thin film package device according to claim 2, wherein the second organic thin film layer (3022) further comprises an organic connecting portion (30222) between adjacent second organic thin film blocks (30221).

4. The thin film package device according to claim 2, wherein the first organic thin film blocks (30210) are arranged in a first direction and/or a second direction, and the first direction and the second direction are perpendicular to each other.

5. The thin film package device according to claim 2, wherein the inorganic thin film layer (301) comprises an inorganic thin film isolation layer (3010) between the first organic thin film layer (3021) and the second organic thin film layer (3022).

6. The thin film package device according to claim 5, wherein the inorganic thin film layer (3010) further comprises a first inorganic thin film layer (3011) in contact with the device (20) to be packaged and a second inorganic thin film layer (3012) disposed on the outmost side of the thin film package device.

7. The thin film package device according to claim 1, wherein the organic thin film layer (302) has a thickness of between 1 and 10 µm.

8. The thin film package device according to claim 1, wherein the device (20) to be packaged comprises a photoelectric functional layer (201) and an electrode layer (202) disposed on a surface of the photoelectric functional layer (201).

9. A solar cell comprising the thin film package device according to any one of claims 1 to 8 and a solar cell module.
